Europäisches Patentamt

European Patent Office

Office européen des brevets

(19)

(11) EP 0 428 765 B1

(12) **EUROPÄISCHE PATENTSCHRIFT**

(45) Veröffentlichungstag und Bekanntmachung des Hinweises auf die Patenterteilung:
**23.10.1996 Patentblatt 1996/43**

(51) Int Cl.[6]: **H03C 3/00**, H04N 5/92

(21) Anmeldenummer: **89121402.5**

(22) Anmeldetag: **18.11.1989**

(54) **Verfahren und Vorrichtung zur Frequenzmodulation**

Method and device for frequency modulation

Procédé et dispositif de modulation en fréquence

(84) Benannte Vertragsstaaten:
**DE FR NL**

(43) Veröffentlichungstag der Anmeldung:
**29.05.1991 Patentblatt 1991/22**

(73) Patentinhaber: **Deutsche ITT Industries GmbH**
**79108 Freiburg (DE)**

(72) Erfinder: **Winterer, Martin, Dipl.-Phys.**
**D-7803 Gundelfingen (DE)**

(56) Entgegenhaltungen:
EP-A- 0 068 535      US-A- 3 654 450
US-A- 3 868 599      US-A- 4 802 016

• E.STADLER, "Modulationsverfahren", Kamprath-Reihe.Technik, 3.Auflage, 1983, Seiten 95-97 und 101, Vogel-Buchverlag, Würzburg, DE

EP 0 428 765 B1

## Beschreibung

Die Erfindung betrifft ein Verfahren und eine Vorrichtung zur Frequenzmodulation eines Trägerfrequenzsignals mit einem Modulationssignal, die je in zeitdiskreten Abtastwerten vorliegen. Insbesondere betrifft die Erfindung eine Methode zur Frequenzmodulation, bei welcher das Trägerfrequenzsignal und das Modulationssignal je in binär kodierter Form vorliegen.

Aus US-A 3 868 599 ist ein Einseitenband-Frequenzmodulationsverfahren mit zugehöriger Blockschaltung bekannt, bei dem das zu modulierende Signal in einen niederen und einen hohen Frequenzbereich aufgespalten wird, die getrennt frequenzmoduliert und wieder zusammengeführt werden. Mittels eines Exporentialfunktionsgenerators in einem Signalzweig werden dabei alle Seitenbänder mit negativem Vorzeichen unterdrückt, während die positiven Seitenbänder nicht verändert werden. Eine Begrenzung in der Erstreckung der Seitenbänder findet nicht statt.

Seit digitale integrierte Schaltungen verfügbar sind, die sich mit genügend hohen Taktfolgefrequenzen betreiben lassen, hat die Digitalisierung der Videosignalverarbeitung in Fernsehempfängern und Videorekordern Eintritt gefunden. Wie dem "Elektronik-Sonderheft", Nr. 57, 1984, Seiten 97 bis 100 entnehmbar ist, wird bei Videorekordern die Luminanzinformation von dem ursprünglich amplitudenmodulierten FBAS-Signal zur Aufzeichnung auf das Magnetband frequenzmoduliert. In der genannten Druckschrift ist ein Prinzipschaltbild eines digitalen FM-Modulators dargestellt. Er umfaßt einen ersten Addierer, dem das Modulationssignal in digitaler Form zugeführt wird. Dem ersten Addierer schließt sich eine Integrierschaltung an, die einen zweiten Addierer und einen Speicher sowie eine Rückkopplung vom Speicherausgang auf den zweiten Addierer aufweist. An den Ausgang der Integrierschaltung ist eine Sinus-Tabelle angeschlossen. Deren Ausgang bildet den Ausgang des digitalen FM-Modulators.

Wird mit einem derartigen digitalen FM-Modulator eine Frequenzmodulation durchgeführt, an welcher im Vergleich zur Abtastfrequenz hohe Frequenzanteile beteiligt sind, treten aufgrund der Modulation hohe Seitenbänder auf, von denen Frequenzen in das Nutzfrequenzband zurückfallen können, sogenannte Alias-Signale. Da sie im Nutzfrequenzband auftreten, können sie nach ihrer Entstehung nicht mehr durch Filterung eliminiert werden.

Der Erfindung liegt die Aufgabe zugrunde, eine Methode zur Frequenzmodulation verfügbar zu machen, mit welcher das Auftreten solcher störenden Alias-Signale von vornherein verhindert wird.

Eine verfahrensmäßige Lösung dieser Aufgabe ist im Anspruch 1 angegeben und kann den Ansprüchen 2 bis 4 gemäß vorteilhaft weitergebildet werden. Eine vorrichtungsmäßige Lösung ist in Ansprüchen 5 und 7 angegeben und kann gemäß den Ansprüchen 6 bis 8 vorteilhaft weitergebildet werden.

Die vorliegende Erfindung basiert auf der grundlegenden Idee, das Modulationssignal in einen niederfrequenten und in einen hochfrequenten Modulationssignalanteil aufzutrennen und beide Signalteile einer unterschiedlichen Modulationsmethode zu unterwerfen. Der niederfrequente Modulationssignalanteil, der störende Alias-Signale nicht hervorruft, wird einer üblichen Frequenzmodulation unterzogen. Der hochfrequente Modulationssignalanteil wird einer Schmalband-Frequenzmodulation unterworfen. Die Auftrennung in den niederfrequenten und in den hochfrequenten Modulationssignalanteil geschieht mit Hilfe eines Tiefpasses. Die aus den beiden Modulationen hervorgehenden modulierten Signale werden dann wieder vereint. Das vereinte Signal bildet das Ausgangssignal des gesamten FM-Modulators.

Eine bevorzugte Ausführungsform eines erfindungsgemäßen digitalen Frequenzmodulators umfaßt drei Integrierschaltungen, die je Abtastwert eine sägezahnförmige Schwingung konstanter Amplitude erzeugen, deren Frequenz sich in Abhängigkeit von dem auf diese Integrierschaltung einwirkenden Modulationssignalanteil ändert. Zwei dieser Integrierschaltungen werden von dem Ausgangssignal einer Addierschaltung gespeist, der über einen ersten Eingang ein den Träger darstellendes Signal und über einen zweiten Eingang der am Ausgang eines Tiefpaßfilters gewonnene niederfrequente Modulationssignalanteil zugeführt wird. Die Abtastwerte der beiden Integrierschaltungen werden mittels einer Sinus-Tabelle bzw. einer Cosinus-Tabelle in die Abtastwerte einer Sinus- bzw. Cosinus-Schwingung umgesetzt. Der hochfrequente Modulationssignalanteil, der aus der Subtraktion des niederfrequenten Modulationssignalanteils von dem gesamten Modulationssignal gewonnen wird, wird in einer weiteren Integrierschaltung verarbeitet. Das Ausgangssignal dieser Integrierschaltung und das Ausgangssignal der Cosinus-Tabelle werden multipliziert. Das resultierende Produkt wird in einer zweiten Addierstufe zu dem Ausgangssignal der Sinus-Tabelle addiert. Der Ausgang der zweiten Addierstufe bildet den Ausgang des gesamten FM-Modulators.

Eine schaltungsmäßige Vereinfachung kann man dadurch erreichen, daß man anstelle der beiden Integrierschaltungen, die der Sinus-Tabelle bzw. der Cosinus-Tabelle vorgeschaltet sind, eine gemeinsame Integrierschaltung verwendet, deren Ausgangssignal einerseits auf die Sinus-Tabelle und andererseits auf die Cosinus-Tabelle geführt wird.

Eine zusätzliche Schaltungsvereinfachung kann man dadurch erreichen, daß man nur noch eine einzige Integrierschaltung verwendet, die man vor dem Tiefpaß anordnet. Die Sinus-Tabelle und die Cosinus-Tabelle bleiben auf der Ausgangsseite des Tiefpasses. Der entsprechende Eingang der Multiplizierschaltung ist ebenfalls ohne Zwischenschaltung einer weiteren Integrierschaltung mit dem Ausgang einer Subtrahierschaltung verbunden, welche den hochfrequenten Signalanteil abtrennt.

Die Erfindung sowie weitere Aufgabenaspekte und Erfindungsmerkmale werden nun anhand von Ausführungs-

EP 0 428 765 B1

formen näher erläutert. In den Zeichnungen zeigen:

Fig. 1    einen digitalen FM-Modulater herkömmlicher Art;

Fig. 2    eine erste Ausführungsform eines erfindungsgemäßen digitalen FM-Modulators;

Fig. 3    eine zweite Ausführungsform eines erfindungsgemäßen FM-Modulators;

Fig. 4    eine dritte Ausführungsform eines erfindungsgemäßen FM-Modulators; und

Fig. 5    ein Beispiel für die Auftrennung eines Modulationssignals in einen niederfrequenten und einen hochfrequenten Modulationssignalanteil.

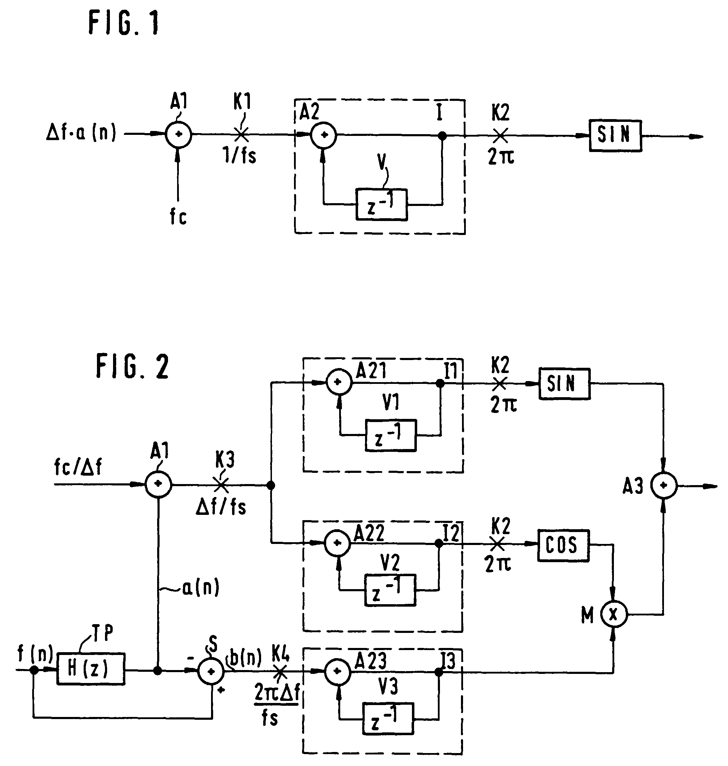

Fig. 1 zeigt in Form eines Blockschaltbildes einen herkömmlichen FM-Modulator, bei welchem sämtliche Frequenzanteile des Modulationssignals auf herkömmliche Weise zur Modulation verwendet werden.

In Fig. 1 ist die Verarbeitung eines niederfrequenten Modulationssignals mit Hilfe eines herkömmlichen FM-Modulators dargestellt. Einer ersten Addierschaltung A1 wird über einen ersten Eingang eine das Modulationssignal darstellende Größe $\Delta f \cdot a(n)$ und über einen zweiten Eingang eine die Trägerfrequenz darstellende Größe fc als konstanter Zahlenwert zugeführt. Das Ausgangssignal der Addierschaltung Al wird mit Hilfe eines ersten Koeffizientengliedes K1 mit einem Koeffizienten 1/fs multipliziert und gelangt dann auf eine Integrierschaltung I. Mit fs ist dabei die Abtastfrequenz bezeichnet. $\Delta f$ ist der Frequenzhub und a(n) ist ein niederfrequenter Modulationssignalanteil. Die Integrierschaltung umfaßt eine zweite Addierschaltung A2 und ein Verzögerungsglied V. Das Verzögerungsglied V ist zwischen den Ausgang und einen der beiden Eingänge der Addierschaltung A2 geschaltet. Das Ausgangssignal der Integrierschaltung I wird mit Hilfe eines zweiten Koeffizientenglieds K 2 mit $2\pi$ multipliziert und gelangt dann auf den Eingang einer Sinus-Tabelle SIN. Der Ausgang der Sinus-Tabelle stellt den Ausgang des FM-Modulators dar. In der Praxis kann der auftretende Faktor $2\pi$ in die SIN-Tabelle eingerechnet werden, so daß diese Multiplikation wegfällt. Ohne den Skalierungs-Koeffizient 1/fs wäre die Akkummulation in der Integrierschaltung I von der jeweiligen Abtastfrequenz fs abhängig. Bei einer fest vorgegebenen Abtastfrequenz fs kann das Koeffizientenglied K1 auch durch die Vorgabe des Speicherumfangs des Verzögerungsglieds V ersetzt werden.

Gibt man ein Modulationssignal, das nicht nur niederfrequente sondern auch hochfrequente Signalanteile enthält, auf den in Fig. 1 gezeigten Frequenzmodulator, entstehen im ausgangsseitigen modulierten Signal Seitenbänder, die von der Modulationsverarbeitung des hochfrequenten Modulationssignalanteils stammen und in das Nutzfrequenzband zurückfallen und dort als Alias-Signale stören.

Dieses Problem wird mit der vorliegenden Erfindung überwunden.

Eine erste Ausführungsform der Erfindung ist in Fig. 2 dargestellt. In dieser Figur sind Schaltungskomponenten, die mit solchen der Fig. 1 übereinstimmen, mit gleichen Bezugszeichen gekennzeichnet.

Der digitale FM-Modulator in Fig. 2 weist einen Tiefpaß TP auf, dessen Eingang das Modulationssignal f(n) zugeführt wird. Das Modulationssignal f(n) gelangt außerdem auf einen addierenden Eingang einer Subtrahierschaltung S, deren subtrahierender Eingang mit dem Ausgang des Tiefpasses verbunden ist. Der Ausgang des Tiefpasses TP ist außerdem mit einem ersten Eingang einer ersten Addierschaltung Al verbunden, der über einen zweiten Eingang das Trägerfrequenzsignal zugeführt wird, das in Fig. 2 in normierter Weise durch fc/$\Delta$f dargestellt ist.

Das Ausgangssignal der Addierschaltung A 1 wird mittels eines Koeffizientengliedes K3 mit einem Koeffizienten $\Delta f/fs$ multipliziert und dann einerseits auf den Eingang einer ersten Integrierschaltung I1 und andererseits auf den Eingang einer zweiten Integrierschaltung I2 gegeben. Das Ausgangssignal einer jeden Integrierschaltung wird mittels eines Koeffizientengliedes K2 mit $2\pi$ multipliziert. Danach wird das von der ersten Integrierschaltung I1 kommende Signal auf eine Sinus-Tabelle SIN gegeben, während das von der zweiten Integrierschaltung I2 kommende Signal auf eine Cosinus-Tabelle COS geführt wird.

Das Ausgangssignal der Subtrahierschaltung S wird mittels eines Koeffizientengliedes K4 mit

$$\frac{2\pi\Delta f}{fs}$$

multipliziert und gelangt dann auf den Eingang einer dritten Integrierschaltung I3. Das Ausgangssignal der Cosinus-Tabelle COS und das Ausgangssignal der dritten Integrierschaltung I3 werden auf je einen Eingang einer Multiplizierschaltung M gegeben. Deren Ausgangssignal und das Ausgangssignal der Sinus-Tabelle SIN werden auf je einen Eingang einer dritten Addierschaltung A3 gegeben. Deren Ausgang stellt den Ausgang des gesamten FM-Modulators dar.

Jede Integrierschaltung weist eine Addierschaltung A21 bzw. A22 bzw. A23 und ein Verzögerungsglied V1 bzw.

V2 bzw. V3 auf, die je in der im Zusammenhang mit Fig. 1 erläuterten Weise miteinander verschaltet sind.

Im folgenden wird die Funktionsweise der in Fig. 2 gezeigten Ausführungsform erläutert, und zwar anhand von mathematischen Betrachtungen. Die Bedeutung der darin verwendeten Symbole wird hier folgendermaßen zusammengestellt:

fc(t):       FM-Ausgangssignal
fc,ωc:      Trägerfrequenz
fs:          Abtastfrequenz
f(t):        Modulationssignal
Δf:          Frequenzhub

$$\alpha = 2\pi\Delta f$$

a(t):        niederfrequenter Modulationssignalanteil
b(t):        hochfrequenter Modulationssignalanteil
Θ (t):       Phasenwinkel des FM-Ausgangssignals.

Zunächst wird die FM-Modulation von analogen, zeitkontinuierlichen Signalen betrachtet. Das FM-Ausgangssignal ist

$$fc(t) = \sin[\Theta(t)] \qquad (1)$$

mit dem Phasenwinkel

$$\Theta(t) = \omega ct + \alpha\int f(t)\, dt \qquad (2)$$

Geht man davon aus, daß das Modulationssignal einen niederfrequenten und einen hochfrequenten Modulationssignalanteil aufweist, ergibt sich

$$f(t) = a(t) + b(t) \qquad (3)$$

$$\Theta(t) = \omega ct + \alpha\int a(t)\, dt + \alpha\int b(t)\, dt \qquad (4)$$

In verkürzter Ausdrucksweise für die beiden Integrale in Gleichung (4) erhält man

$$fc(t) = \sin\omega ct + \alpha\cdot x(t) + \alpha\cdot y(t) \qquad (5)$$

Setzt man Gleichung (5) in Gleichung (1) ein, erhält man für das FM-Ausgangssignal

$$fc(t) = \sin[\omega ct + \alpha x(t) + \alpha y(t)]$$

$$= \sin[\omega ct + \alpha x(t)]\cdot \cos[\alpha y(t)] + \cos[\omega ct + \alpha x(t)]\cdot \sin[\alpha y(t)] \qquad (6)$$

Unter der Annahme

$$|\alpha y(t)| \ll \pi/2 \qquad (7)$$

ergibt sich

$$\cos[\alpha y(t)] = 1 \tag{8}$$

und

$$\sin[\alpha y(t)] = \alpha y(t) \tag{9}$$

Damit ergibt sich für das FM-Ausgangssignal

$$fc(t) = \sin[\omega ct + \alpha x(t)] + \alpha \cdot y(t) \cdot \cos[\omega ct + \alpha x(t)] \tag{10}$$

In verkürzter Schreibweise ergibt sich

$$fc(t) = \sin[\theta_1(t)] + \alpha \cdot y(t) \cdot \cos[\theta_1(t)] \tag{11}$$

Dabei ist

$$\theta_1(t) = \omega ct + \alpha x(t)$$

$$= \omega ct + \alpha \int a(t)\, dt$$

$$= \int [\omega c + \alpha a(t)]\, dt$$

$$= \int [\omega c + 2\pi\Delta f \cdot a(t)]\, dt \tag{12}$$

$\sin[\theta_1(t)]$ entspricht der normalen "Breitband-FM" ("Wide band FM") für den niederfrequenten Modulationssignalanteil a(t).
Der hochfrequente Modulationssignalanteil b(t) dagegen wird einer "Schmalband-FM" ("Narrow band FM") unterworfen.
Für zeitdiskrete Signale gelten folgende Betrachtungen:

$$1/s \,\hat{=}\, 1/fs \cdot 1/(1-z^{-1}) \text{ für } |\omega| \ll \omega s \tag{13}$$

Bei dieser Betrachtung gilt für den Phasenwinkel

$$\theta_1(z) = 1/fs \cdot 1/1-z^{-1} \cdot Z\{\omega c + \alpha \cdot a(n)\}$$

$$= 2\pi/fs \cdot 1/1-z^{-1} \cdot z\{fc + \Delta f \cdot a(n)\} \tag{14}$$

Gleichung (14) zeigt die Phase eines zeitdiskreten FM-Ausgangssignals für den Fall, daß nur niederfrequente Modulationssignalanteile vorhanden sind, wie es im Zusammenhang mit der Erläuterung der Fig. 1 angenommen worden ist.
Im folgenden wird gezeigt, daß die Beziehung (7) für den Fall diskreter Signalverarbeitung erfüllbar ist.

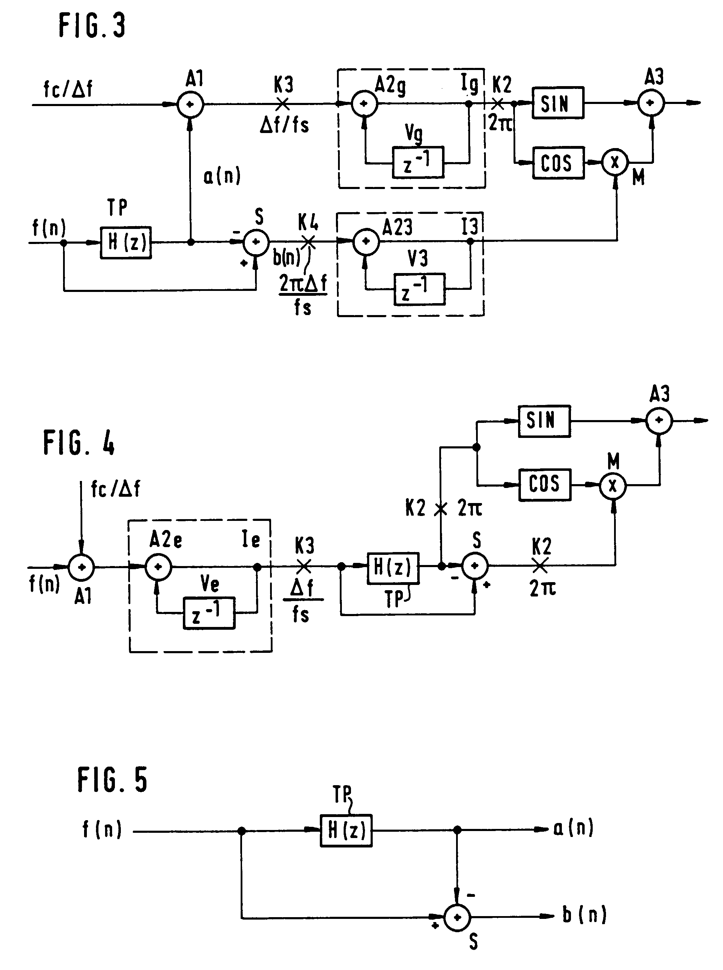

Fig. 5 zeigt ein Beispiel für die Auftrennung eines Modulationssignals f(n) in einen niederfrequenten Modulationssignalanteil a(n) und einen hochfrequenten Modulationssignalanteil b(n). Hierzu werden ein Tiefpaß TP und eine Subtrahierschaltung S verwendet, wie es im Zusammenhang mit Fig. 2 bereits erläutert worden ist.
Drückt man die Eingangs- und Ausgangssignale in Fig. 5 durch entsprechende z-Transformierte aus, kommt man zu folgender Darstellung:

$$A(z) = H(z) \cdot F(z) \tag{15}$$

$$B(z) = \{1 - H(z)\} \, F(z) \tag{16}$$

Dabei ist H(z) die Übertragungsfunktion des Tiefpasses TP in der z-Ebene. F(z) ist das Modulationssignal in der z-Ebene. A(z) und B(z) sind der niederfrequente bzw. der hochfrequente Modulationssignalanteil in der z-Ebene.

Im Fall zeitdiskreter Signale und unter Anwendung der z-Transformation führen der zweite und der dritte Term der Gleichung (4) zu

$$X(z) = 1/fs \cdot 1/(1 - z^{-1}) \cdot H(z) \cdot F(z) \tag{17}$$

bzw.

$$Y(z) = 1/fs \cdot 1(1 - z^{-1}) \cdot (1 - H(z)) \, F(z) \tag{18}$$

Setzt man zum Beispiel

$$H(z) = 1/2 \cdot (1 + z^{-1}) \tag{19}$$

erhält man

$$X(z) = 1/2fs \cdot (1 + z^{-1})/(1 - z^{-1}) \cdot F(z) \tag{20}$$

$$Y(z) = 1/2fs \cdot F(z) \tag{21}$$

Führt man eine Transformation der Gleichung (21) aus der z-Ebene in die zeitdiskrete Darstellung durch, erhält man:

$$\begin{aligned}
\alpha \cdot y(n) &= \frac{\alpha}{2fs} \cdot f(n) \\
&= \frac{2\pi\Delta f}{2fs} \cdot f(n) \\
&= \pi \cdot \frac{\Delta f}{fs} \cdot f(n)
\end{aligned} \tag{22}$$

Für

$$|f(n)| \leq 1 \tag{23}$$

erhält man

$$|\alpha y(n)| \leq \pi \cdot \frac{\Delta f}{fs} \tag{24}$$

Setzt man in diese Beziehung Zahlenwerte ein, wie sie sich aus der Norm für Videorekorder ergeben, ergibt sich:

$$fs = 20{,}25 \text{ MHz}$$

$$fc = 4{,}3 \text{ MHz}$$

$$\Delta f = 0,5 \text{ MHz}.$$

Setzt man diese Zahlenwerte in die Beziehung (24) ein, erhält man:

$$|\alpha y(n)| \leq \pi \cdot \frac{0,5}{20,25} = 0,08 << \frac{\pi}{2} \qquad (25)$$

Dieses Zahlenbeispiel zeigt, daß sich durch geeignete Wahl von H(z) die Bedingung (7) bei zeitdiskreter Signalverarbeitung erfüllten läßt. Es kommt darauf an, daß a(n) keine nennenswerten hochfrequenten Anteile mehr enthält.

Bei der Realisierung gemäß Fig. 2 erfolgt mit Hilfe des Tiefpasses TP die Auftrennung in einen niederfrequenten Modulationssignalanteil a(n) und in einen hochfrequenten Modulationssignalanteil b(n). Der niederfrequente Modulationssignalanteil a(n) wird in der ersten Integrierschaltung I1 und mit Hilfe der Sinus-Tabelle SIN auf herkömmliche Weise frequenzmoduliert. Dies entspricht dem ersten Term der Gleichung (11). Eine Verarbeitung entsprechend dem zweiten Term der Gleichung (11) findet in den Signalpfaden mit der zweiten Integrierschaltung I2 bzw. der dritten Integrierschaltung I3 statt. Am Ausgang der Addierschaltung A3 steht dann ein Signal entsprechend Gleichung (11) zur Verfügung. Das Ausgangssignal der ersten und zweiten Integrierschaltung I1, I2 ist wertemäßig etwa sägezahnförmig, weil die beiden Integrierschaltungen das Eingangssignal solange akkummulieren, bis das erste bzw. zweite Verzögerungsglied V1, V2 durch Bereichsüberlauf wieder bei kleinen Zahlenwerten beginnen. Die dritte Integrierschaltung I 3 wirkt als echter Integrator, denn ihr Ausgangssignal ist stetig, es weist keinen Überlauf auf.

Fig. 3 zeigt eine schaltungstechnisch vereinfachte Ausführungsform der Erfindung. Bei der Ausführungsform nach Fig. 2 wird für die Signalpfade, welche die Sinus- bzw. die Cosinus-Tabelle enthalten, je eine Integrierschaltung gleichen Aufbaus verwendet. In der Praxis reicht eine gemeinsame Integrierschaltung Ig aus, deren wertemäßig sägezahnförmiges Ausgangssignal einerseits auf die Sinus-Tabelle und andererseits auf die Cosinus-Tabelle geführt wird, wie es in Fig. 3 gezeigt ist. Dabei weist die gemeinsame Integrierschaltung Ig eine zweite Addierschaltung A2g und ein gemeinsames Verzögerungsglied Vg auf. Ansonsten stimmt die Ausführungsform nach Fig. 3 mit der nach Fig. 2 überein.

Eine weitere schaltungstechnische Vereinfachung erreicht man mit der Ausführungsform nach Fig. 4, die eine modifizierte Schaltungsstruktur mit Modulo-Arithmetik darstellt. Bei dieser Ausführungsform ist nur noch eine einzige Integrierschaltung Ie vorhanden, die eine zweite Addierschaltung A2e und ein Verzögerungsglied Ve enthält.

Diese Integrierschaltung Ie ist vor dem Tiefpaß TP angeordnet. Hier wird also die Sägezahnbildung mit Hilfe der Integrierschaltung unter Beeinflußung durch alle Frequenzkomponenten des Modulationssignals durchgeführt. Die einzelnen Komponenten des daraus resultierenden Mischsignals werden durch den Tiefpaß TP in niederfrequente und hochfrequente Anteile aufgetrennt. Die niederfrequenten Anteile werden der Sinus- bzw. der Cosinus-Tabelle zugeführt. Danach findet dann eine Multiplikation mit der Multiplikationsschaltung M und eine Addition mit der Additionsschaltung A3 statt, wie bei den anderen Ausführungsformen.

**Patentansprüche**

1.  Verfahren zur Frequenzmodulation eines binär Kodierten Trägerfrequenzsignals (fc) mit einem binär Kodierten Modulationssignal (f(n)), die je in zeitdiskreten Abtastwerten vorliegen,
    <u>dadurch gekennzeichnet,</u>

    -   daß das Modulationssignal entweder direkt oder mit dem Trägerfrequenzsignal vereint einen niederfrequenten und in einen hochfrequenten Signalanteil zerlegt wird,

    -   daß mit dem niederfrequenten Signalanteil eine digitale Breitband-Frequenzmodulation durchgeführt wird,

    -   daß mit dem hochfrequenten Signalanteil eine digitale Schmalband-Frequenzmodulation durchgeführt wird,

    -   und daß das aus der Breitband-Frequenzmodulation resultierende Signal und das aus der Schmalband-Frequenzmodulation resultierende Signal vereint werden.

2.  Verfahren nach Anspruch 1,
    dadurch **gekennzeichnet**,
    daß das Modulationssignal mit Hilfe eines Tiefpasses zerlegt wird.

3.  Verfahren nach Anspruch 1 oder 2,

dadurch **gekennzeichnet**,
daß das Trägerfrequenzsignal und das Modulationssignal der Frequenzmodulation in Form von wert- und zeitdiskreten Werten zugeführt werden.

4. Verfahren nach Anspruch 3,
dadurch **gekennzeichnet**,
daß das Trägerfrequenzsignal und das Modulationssignal der Frequenzmodulation in binär kodierter Form zugeführt werden.

5. Digitaler Frequenzmodulator zur Durchführung des Verfahrens nach einem der Ansprüche 1 bis 4, mit einer Integriereinrichtung, deren Ausgangssignal beim Erreichen eines Maximalwerts auf einen Minimalwert übergeht, wobei die durch das Trägerfrequenzsignal vorgegebene Steilheit der Integrationsflanke des Ausgangssignals der Integriereinrichtung sich mit dem Wert des Modulationssignals ändert,
dadurch **gekennzeichnet**,

daß eine Tiefpaßschaltung (TP) zur Abtrennung eines niederfrequenten Modulationssignalanteils (a (n)) vorgesehen ist, dessen Eingang das Modulationssignal (f (n)) zugeführt wird,
daß eine erste Addierschaltung (A1) vorgesehen ist,
der über einen ersten Eingang das Trägerfrequenzsignal (fc/$\Delta$f) zugeführt wird und die mit einem zweiten Eingang mit dem Ausgang des Tiefpasses (TP) verbunden bunden ist,
daß die Integriereinrichtung drei Integrierschaltungen (I1,I2, I3) aufweist,
daß die erste Integrierschaltung (I1) und die zweite Integrierschaltung (I2) eingangsseitig je mit dem Ausgang der ersten Addierschaltung (A1) und ausgangsseitig mit dem Eingang einer Sinus-Tabelle (SIN) bzw. einer Cosinus-Tabelle (COS) gekoppelt sind,
daß zur Abtrennung eines hochfrequenten Modulationssignalanteils (b(n)) eine Subtrahierschaltung (S) vorgesehen ist, deren addierendem Eingang das Modulationssignal (f(n)) zugeführt wird und deren subtrahierender Eingang mit dem Ausgang der Tiefpaßschaltung (TP) verbunden ist,
daß der Eingang der dritten Integrierschaltung (I3) mit dem Ausgang der Subtrahierschaltung (S) gekoppelt ist, daß eine Multiplizierschaltung (M) vorgesehen ist, die über einen ersten Eingang mit dem Ausgang der Cosinus-Tabelle (COS) und über einen zweiten Eingang mit dem Ausgang der dritten Integrierschaltung (I3) gekoppelt ist,
und daß eine weitere Addierschaltung (A3) vorgesehen ist, die über einen ersten Eingang mit dem Ausgang der Sinus-Tabelle (SIN) und über einen zweiten Eingang mit dem Ausgang der Multiplizierschaltung (M) gekoppelt ist und deren Ausgang den Ausgang des Frequenzmodulators bildet.

6. Frequenzmodulator nach Anspruch 5,
dadurch **gekennzeichnet**,
daß anstelle der ersten und der zweiten Integrierschaltung (I1, I2) eine gemeinsame Integrierschaltung (Ig) vorgesehen ist, deren Ausgang mit dem Eingang sowohl der Sinus-Tabelle (SIN) als auch der Cosinus-Tabelle (COS) gekoppelt ist.

7. Digitaler Frequenzmodulator zur Durchführung des Verfahrens nach einem der Ansprüche 1 bis 4, mit einer Integriereinrichtung, deren Ausgangssignal beim Erreichen eines Maximalwerts auf einen Minimalwert übergeht, wobei die durch das Trägerfrequenzsignal vorgegebene Steilheit der Integrationsflanke des Ausgangssignals der Integriereinrichtung sich mit dem Wert des Modulationssignals ändert,
dadurch gekennzeichnet,

- daß eine einzige Integrierschaltung (Ie) vorgesehen ist, deren Eingang mit dem Ausgang einer ersten Addierschaltung (A1) und deren Ausgang mit dem Eingang einer Tiefpaßschaltung (TP) gekoppelt sind,

- daß der eine Eingang der ersten Addierschaltung (A1) mit dem Modulationssignal (f(n)) und der andere Eingang mit dem Trägerfrequenzsignal (fc) gespeist sind,

- daß zur Abtrennung eines hochfrequenten Signalanteils eine Subtrahierschaltung (S) vorgesehen ist, deren addierendem Eingang das Ausgangssignal der einzigen Integrierschaltung (Ie) zugeführt wird und deren subtrahierender Eingang mit dem Ausgang der Tiefpaßschaltung (TP) verbunden ist,

- daß der Ausgang der Tiefpaßschaltung (TP) mit dem Eingang einerseits einer Sinus-Tabelle (SIN) und andererseits einer Cosinus-Tabelle (COS) gekoppelt ist,

- daß eine Multiplizierschaltung (M) vorgesehen ist, die über einen ersten Eingang mit dem Ausgang der Cosinus-Tabelle (COS) und über einen zweiten Eingang mit dem Ausgang der Subtrahierschaltung (S) gekoppelt ist,

- und daß eine weitere Addierschaltung (A3) vorgesehen ist, die über einen ersten Eingang mit dem Ausgang der Sinus-Tabelle (SIN) und über einen zweiten Eingang mit dem Ausgang der Multiplizierschaltung (M) gekoppelt ist und deren Ausgang den Ausgang des Frequenzmodulators bildet.

8. Frequenzmodulator nach mindestens einem der Ansprüche 5 bis 7,
dadurch **gekennzeichnet**,
daß die bzw. jede Integrierschaltung einen Addierer (A21, A22, A23; A2g, A23; A2e) mit einem mit dem zu integrierenden Signal beaufschlagten ersten Eingang, einem zweiten Eingang und einem Ausgang und ein Verzögerungsglied (V1, V2, V3; Vg, V3; Ve), das zwischen den Ausgang und den zweiten Eingang dieses Addierers geschaltet ist, aufweist.

## Claims

1. A method of frequency-modulating a binary-coded carrier-frequency signal (fc) with a binary-coded modulating signal (f(n)) which are each present as time-discrete sample values,
<u>characterized in</u>

- that the modulating signal is separated, either directly or together with the carrier-frequency signal, into a low-frequency component and a high-frequency component,

- that the low-frequency component is used to effect digital broadband frequency modulation,

- that the high-frequency component is used to effect digital narrow-band frequency modulation, and

- that the signal resulting from the broadband frequency modulation and the signal resulting from the narrow-band frequency modulation are united.

2. A method as claimed in claim 1,
**characterized in**
that the modulating signal is separated with the aid of a low-pass filter.

3. A method as claimed in claim 1 or 2,
**characterized in**
that the carrier-frequency signal and the modulating signal are presented to the frequency modulation in the form of value- and time-discrete values.

4. A method as claimed in claim 3,
**characterized in**
that the carrier-frequency signal and the modulating signal are presented to the frequency modulation in binary-coded form.

5. A digital frequency modulator for carrying out the method according to any one of claims 1 to 4, comprising an integrating facility whose output signal changes to a minimum value upon reaching a maximum value, with the steepness of the integration slope of the output signal of the integrating facility varying with the value of the modulating signal, said steepness being determined by the carrier-frequency signal,
**characterized in**

that a low-pass filter (TP) whose input is supplied with the modulating signal (f(n)) is provided for separating a low-frequency component (a(n)) from said modulating signal,
that a first adder (A1) is provided which is supplied with the carrier-frequency signal (fc/Δf) via a first input and which has a second input connected to the output of the low-pass filter (TP),

that the integrating facility consists of three integrators (I1, I2, I3),

that the first integrator (I1) and the second integrator (I2) are coupled at the input end to the output of the first adder (A1) and at the output end to the inputs of a sine table (SIN) and a cosine table (COS), respectively,

that to obtain a high-frequency modulating-signal component (b(n)), a subtracter (S) is provided whose add input is supplied with the modulating signal (f(n)) and whose subtract input is connected to the output of the low-pass filter (TP),

that the input of the third integrator (I3) is coupled to the ouptut of the subtracter (S),

that a multiplier (M) is provided which is coupled via a first input to the output of the cosine table (COS) and via a second input to the output of the third integrator (I3), and

that an additional adder (A3) is provided which is coupled via a first input to the output of the sine table (SIN) and via a second input to the output of the multiplier (M), and whose output forms the output of the frequency modulator.

6.  A frequency modulator as claimed in claim 5,
    **characterized in**
    that instead of the first and second integrators (I1, I2), a common integrator (Ig) is provided whose output is coupled to the input of both the sine table (SIN) and the cosine table (COS).

7.  A digital frequency modulator for carrying out the method according to any one of claims 1 to 4, comprising an integrating facility whose output signal changes to a minimum value upon reaching a maximum value, with the steepness of the integration slope of the output signal of the integrating facility varying with the value of the modulating signal, said steepness being determined by the carrier-frequency signal,
    **characterized in**

    -   that a single integrator (Ie) is provided whose input is coupled to the output of the first adder (A1) and whose output is coupled to the input of a low-pass filter (TP),

    -   that one input of the first adder (A1) is fed with the modulating signal (f(n)), and the other with the carrier-frequency signal (fc),

    -   that to obtain a high-frequency signal component, a subtracter (S) is provided whose add input is supplied with the output signal from the single integrator (Ie) and whose subtract input is connected to the output of the low-pass filter (TP),

    -   that the output of the low-pass filter (TP) is coupled to the inputs of a sine table (SIN) and a cosine table (COS), and

    -   that a multiplier (M) is provided which is coupled via a first input to the output of the cosine table (COS) and via a second input to the output of the subtracter (S).

8.  A frequency modulator as claimed in at least one of claims 5 to 7,
    **characterized in**
    that the or each integrator comprises an adder (A21, A22, A23; A2g, A23; A2e) having a first input to which the signal to be integrated is applied, a second input, and an output, and a delay element (V1, V2, V3; Vg, V3; Ve) connected between the output and the second input of said adder.

**Revendications**

1.  Procédé de modulation de fréquence d'un signal de fréquence porteuse (fc) codé en binaire, avec un signal de modulation (f(n)) codé en binaire, ces signaux étant présents respectivement sous la forme de valeurs d'échantillonnage discrètes dans le temps,
    <u>caractérisé en ce</u>

    -   que le signal de modulation est décomposé soit directement, soit, en étant réuni au signal de fréquence porteuse, en une composante de signal à basse fréquence et en une composante de signal à haute fréquence,
    -   qu'une modulation de fréquence numérique à large bande est exécutée avec la composante de signal à basse fréquence,

- qu'une modulation de fréquence numérique à bande étroite est exécutée avec la composante de signal à haute fréquence, et
- qu'on réunit le signal résultant de la modulation de fréquence à large bande et le signal résultant de la modulation de fréquence à bande étroite.

2. Procédé selon la revendication 1, caractérisé en ce que le signal de modulation est décomposé à l'aide de filtres passe-bas.

3. Procédé selon la revendication 1 ou 2, caractérisé en ce que le signal de fréquence porteuse et le signal de modulation sont soumis à la modulation de fréquence, sous la forme de valeurs discrètes en valeurs et de valeurs discrètes dans le temps.

4. Procédé selon la revendication 3, caractérisé en ce que le signal de fréquence porteuse et le signal de modulation sont soumis à la modulation de fréquence sous une forme codée en binaire.

5. Modulateur de fréquence numérique pour la mise en oeuvre du procédé selon l'une des revendications 1 à 4, comportant un dispositif d'intégration, dont le signal de sortie est commuté sur une valeur minimale, lorsqu'une valeur maximale est atteinte, la pente, qui est prédéterminée par le signal de fréquence porteuse, du flanc d'intégration du signal de sortie du dispositif d'intégration variant avec la valeur du signal de modulation, <u>caractérisé en ce</u>

    qu'il est prévu un circuit formant filtre passe-bas (TP) pour séparer une composante de signal de modulation à basse fréquence (a(n)) et à l'entrée duquel est envoyé le signal de modulation (f(n)),

    qu'il est prévu un premier circuit additionneur (A1), auquel le signal de fréquence porteuse (fc/$\Delta$f) est envoyé par l'intermédiaire d'une première entrée et qui est relié, par une seconde entrée, à la sortie du filtre passe-bas (TP),

    que le dispositif d'intégration comporte trois circuits intégrateurs (I1,I2,I3),

    que le premier circuit intégrateur (I1) et le second circuit intégrateur (I2) sont couplés côté entrée respectivement à la sortie du premier circuit additionneur (A1) et côté sortie à l'entrée d'une table de sinus (SIN) ou à une table de cosinus (COS),

    que pour la séparation d'une composante de signal de modulation à haute fréquence (b(n)), il est prévu un circuit soustracteur (S), à l'entrée d'addition duquel est envoyé le signal de modulation (f(n)) et dont l'entrée du nombre à soustraire est reliée à la sortie du circuit formant filtre passe-bas (TP),

    que l'entrée du troisième circuit intégrateur (I3) est couplée à la sortie du circuit soustracteur (S),

    qu'il est prévu un circuit multiplicateur (M), qui est couplé par l'intermédiaire d'une première entrée à la sortie de la table de cosinus (COS) et, par l'intermédiaire d'une seconde entrée, à la sortie du troisième circuit intégrateur (I3), et

    qu'il est prévu un autre circuit additionneur (A3), qui est couplé, par l'intermédiaire d'une première entrée à la sortie de la table de sinus (SIN) et par l'intermédiaire d'une seconde entrée à la sortie du circuit multiplicateur (M) et dont la sortie forme la sortie du modulateur de fréquence.

6. Modulateur de fréquence selon la revendication 5, caractérisé en ce qu'à la place des premier et second circuits intégrateurs (I1,I2), il est prévu un circuit intégrateur commun (Ig), dont la sortie est couplée à l'entrée aussi bien de la table de sinus (SIN) qu'à la table de cosinus (COS).

7. Modulateur de fréquence numérique pour la mise en oeuvre du procédé selon l'une des revendications 1 à 4, comportant un dispositif d'intégration, dont le signal de sortie se transforme en une valeur minimale lorsqu'est atteinte une valeur maximale, la pente, qui est prédéterminée par le signal de fréquence porteuse, du flanc d'intégration du signal de sortie du dispositif d'intégration variant avec la valeur du signal de modulation, <u>caractérisé par</u> le fait

- qu'il est prévu un seul circuit intégrateur (Ie), dont l'entrée est couplée à la sortie d'un premier circuit additionneur (A1) et dont la sortie est couplée à l'entrée d'un circuit formant filtre passe-bas (TP),
- qu'une entrée du premier circuit additionneur (A1) est alimentée par le signal de modulation (f(n)) et que l'autre entrée est alimentée par le signal à la fréquence porteuse (f(c)),
- que pour la séparation d'une composante de signal à haute fréquence, il est prévu un circuit soustracteur (s), à l'entrée d'addition duquel est envoyé le signal de sortie du circuit intégrateur unique (Ie) et dont l'entrée du nombre à soustraire est reliée à la sortie du circuit formant filtre passe-bas (TP),
- que la sortie du circuit formant filtre passe-bas (TP) est couplée d'une part à l'entrée d'une table de sinus (SIN) et d'autre part à l'entrée d'une table de cosinus (COS),

- qu'il est prévu un multiplicateur (M) qui est couplé par une première entrée à la sortie de la table de cosinus (COS) et par une seconde entrée, à la sortie du circuit soustracteur (S) et

- qu'il est prévu un autre circuit additionneur (A3), qui est couplé, par l'intermédiaire d'une première entrée à la sortie de la table de sinus (SIN) et par l'intermédiaire d'une seconde entrée à la sortie du circuit multiplicateur (M) et dont la sortie forme la sortie du modulateur de fréquence.

8. Modulateur de fréquence selon au moins l'une des revendications 5 à 7, caractérisé en ce que le ou chaque circuit intégrateur comporte un additionneur (A21, A22, A23;A2g,A23;A2e) comportant une première entrée chargée par le signal devant être intégré, une seconde entrée et une sortie, et un circuit de retardement (V1,V2,V3;Vg,V3;Ve), qui est branché entre la sortie et la seconde entrée de cet additionneur.

# FIG. 1

# FIG. 2

EP 0 428 765 B1

# FIG.3

# FIG. 4

# FIG. 5

14